(19) Europäisches Patentamt
European Patent Office
Office européen des brevets

(11) **EP 4 184 791 A1**

(12) **DEMANDE DE BREVET EUROPEEN**

(43) Date de publication:
**24.05.2023 Bulletin 2023/21**

(21) Numéro de dépôt: **22207851.1**

(22) Date de dépôt: **16.11.2022**

(51) Classification Internationale des Brevets (IPC):
***H03K 5/134*** (2014.01)      ***H03L 7/08*** (2006.01)

(52) Classification Coopérative des Brevets (CPC):
**H03K 5/134; G06F 1/022; H03L 7/093;**
**H03L 7/0995;** H03K 2005/00058

(84) Etats contractants désignés:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Etats d'extension désignés:
**BA**
Etats de validation désignés:
**KH MA MD TN**

(30) Priorité: **19.11.2021 FR 2112261**

(71) Demandeurs:
• **STMICROELECTRONICS (GRENOBLE 2) SAS**
**38000 Grenoble (FR)**

• **STMicroelectronics (Rousset) SAS**
**13790 Rousset (FR)**

(72) Inventeurs:
• **MUREDDU, Ugo**
**13710 Fuveau (FR)**
• **PELISSIER, Gilles**
**38800 Champagnier (FR)**
• **REYMOND, Guillaume**
**13080 Luynes (FR)**

(74) Mandataire: **Cabinet Beaumont**
**4, Place Robert Schuman**
**B.P. 1529**
**38025 Grenoble Cedex 1 (FR)**

(54) **GÉNÉRATEUR D'UN SIGNAL VOBULÉ**

(57) La présente description concerne un générateur (100) d'un signal numérique vobulé (WO_OUT) comprenant une chaine (104) d'éléments de retard (N1, ..., N12) activables adaptés à retarder un signal numérique (SIG) parmi lesquels un premier nombre de premiers éléments sont actifs, un nombre de deuxièmes éléments sont sélectionnables, et un troisième nombre de troisièmes éléments sont désactivés, la durée entre deux fronts montants consécutifs dudit signal numérique vobulé étant définie par la sélection d'un quatrième nombre des deuxièmes éléments,

le générateur (100) comprenant un circuit de commande (105) adapté à modifier les premiers et troisième nombres si la fréquence moyenne dudit signal numérique vobulé (WO_OUT) est différente d'une fréquence de référence.

**Fig. 1**

EP 4 184 791 A1

**Description**

Domaine technique

La présente description concerne de façon générale les dispositifs et systèmes adaptés à générer des signaux numériques, et plus particulièrement, les dispositifs et systèmes adaptés à générer des signaux numériques vobulés. La présente description présente, en outre, des moyens de régulation d'un signal numérique vobulé.

Technique antérieure

Un signal vobulé est un signal oscillant dont la fréquence varie dans le temps. Plus particulièrement, un signal peut être un signal de forme sensiblement créneau ayant un rapport cyclique sensiblement constant, par exemple constant, et dont la fréquence varie dans le temps.

Il serait souhaitable de pouvoir améliorer, au moins en partie, certains aspects des dispositifs adaptés à générer un signal vobulé.

Résumé de l'invention

Il existe un besoin pour un dispositif adapté à générer un signal vobulé plus performant.

Il existe un besoin pour un dispositif adapté à générer un signal vobulé pouvant réguler la fréquence moyenne du signal vobulé.

Un mode de réalisation pallie tout ou partie des inconvénients des dispositifs connus adaptés à générer un signal numérique vobulé.

Un mode de réalisation prévoit un générateur d'un signal numérique vobulé comprenant une chaine d'éléments de retard activables adaptés à retarder un signal numérique parmi lesquels un premier nombre de premiers éléments sont actifs, un second nombre de deuxièmes éléments sont sélectionnables, et un troisième nombre de troisièmes éléments sont désactivés, la durée entre deux fronts montants consécutifs dudit signal numérique vobulé étant définie par la sélection d'un quatrième nombre des deuxièmes éléments, le générateur comprenant un circuit de commande adapté à modifier les premiers et troisième nombres si la fréquence moyenne dudit signal numérique vobulé est différente d'une fréquence de référence.

Un autre mode de réalisation prévoit un procédé de commande d'un générateur d'un signal numérique vobulé comprenant une chaine d'éléments de retard activables adaptés à retarder un signal numérique parmi lesquels un premier nombre de premiers éléments sont actifs, un second nombre de deuxièmes éléments sont sélectionnables, et un troisième nombre de troisièmes éléments sont désactivés, la durée entre deux fronts montants consécutifs dudit signal numérique vobulé étant définie par la sélection d'un quatrième nombre des deuxièmes éléments, le générateur comprenant un circuit de commande adapté à modifier les premiers et troisième nombres si la fréquence moyenne dudit signal numérique vobulé est différente d'une fréquence de référence.

Selon un mode de réalisation, le deuxième nombre est toujours constant.

Selon un mode de réalisation, le deuxième nombre est variable.

Selon un mode de réalisation, si la fréquence moyenne dudit signal est supérieure à la fréquence de référence alors le premier nombre est augmenté, et le troisième nombre est diminué.

Selon un mode de réalisation, si la fréquence moyenne dudit signal est inférieure à la fréquence de référence alors le premier nombre est diminué, et le troisième nombre est augmenté.

Selon un mode de réalisation, le circuit de commande comprend :

- un générateur d'un signal d'horloge à fréquence constante dont la fréquence est la fréquence de référence ;
- un compteur ; et
- un circuit de compensation calculant une commande de régulation H.

Selon un mode de réalisation, ledit générateur d'un signal d'horloge à fréquence constante est une boucle à verrouillage de phase.

Selon un mode de réalisation, tous les éléments de retard ajoutent une durée de retard identique à un signal numérique, et la commande de régulation H est calculée en utilisant la formule mathématique suivante :

$$H = \frac{\left(\dfrac{C}{Rf} - \dfrac{C}{M}\right)}{S}$$

dans laquelle :

- C représente la durée pendant laquelle ledit compteur effectue son calcul ;
- Rf représente le nombre de fronts montants de référence ;
- M représente la valeur mesurée par le compteur pendant la durée C ; et
- S représente la durée d'un retard d'un élément de retard.

Selon un mode de réalisation, tous les éléments de retard ajoutent un retard identique à un signal numérique, et la commande de régulation H est calculée en utilisant la formule mathématique suivante :

$$H = (M - Rf) * K$$

dans laquelle :

- Rf représente le nombre de fronts montants de référence ;
- M représente la valeur mesurée par le compteur pendant la durée C ; et
- K est une constante dépendant des durées C et S.

Selon un mode de réalisation, la constante K est donnée par la formule mathématique suivante :

$$K = \frac{C * S}{Rf * M}$$

Selon un mode de réalisation, tous les éléments de retard ajoutent un retard identique à un signal numérique, et la commande de régulation H est calculée en utilisant la formule mathématique suivante :

$$H = (Rf - M)\frac{(2 * T\_clk\_ref)}{S * DIV}$$

dans laquelle :

- Rf représente le nombre de fronts montants de référence ;
- M représente la valeur mesurée par le compteur ;
- S représente la durée d'un retard d'un élément de retard ;
- T_clk_ref représente la période du signal de référence Ref ; et
- DIV représente le nombre de fronts montants relevé par un circuit diviseur de fréquence activant ledit compteur.

Un autre mode de réalisation prévoit un générateur de nombres aléatoires comprenant au moins un générateur d'un signal numérique vobulé décrit précédemment.

Un autre mode de réalisation prévoit un générateur de nombres aléatoires comprenant au moins deux générateurs de signaux numériques vobulés décrits précédemment.

Un autre mode de réalisation prévoit un dispositif adapté à mettre en oeuvre une fonction physique inclonable comprenant au moins un générateur d'un signal vobulé décrit précédemment.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, de façon schématique et sous forme de blocs, un mode de réalisation d'un générateur d'un signal numérique vobulé ;

la figure 2 représente deux chronogrammes illustrant le fonctionnement du générateur de la figure 1 ;

la figure 3 représente un schéma logique d'un exemple de réalisation d'un élément de retard du générateur de la figure 1 ;

la figure 4 représente, schématiquement et sous forme de blocs, un exemple de réalisation d'une unité de régulation du générateur de la figure 1 ;

la figure 5 représente, schématiquement et sous forme de blocs, un autre exemple de réalisation d'une unité de régulation du générateur de la figure 1 ;

la figure 6 représente, schématiquement et sous forme de blocs, un exemple de réalisation d'un générateur de nombres aléatoires utilisant un générateur de la figure 1 ;

la figure 7 représente, schématiquement et sous forme de blocs, un autre exemple de réalisation d'un générateur de nombres aléatoires utilisant un générateur de la figure 1 ; et

la figure 8 représente, schématiquement et sous forme de blocs, un exemple d'un mode de réalisation d'un dispositif adapté à mettre en oeuvre une fonction physique inclonable (Physical Unclonable function, PUF).

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.
Par souci de clarté, seuls les étapes et éléments utiles à la compréhension des modes de réalisation décrits ont été représentés et sont détaillés.
Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.
Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.
Sauf précision contraire, les expressions "environ", "approximativement", "sensiblement", et "de l'ordre de" signifient à 10 % près, de préférence à 5 % près.
Les signaux évoqués dans la description sont des signaux numériques comprenant un état haut et un état bas correspondant, respectivement, à des données logiques "1" et "0". L'état haut représente, sauf mention contraire, un niveau haut de tension, par exemple, égal à une tension d'alimentation. L'état bas représente, sauf mention contraire, un niveau bas de tension, par exemple, égal à une tension de référence, par exemple la masse.

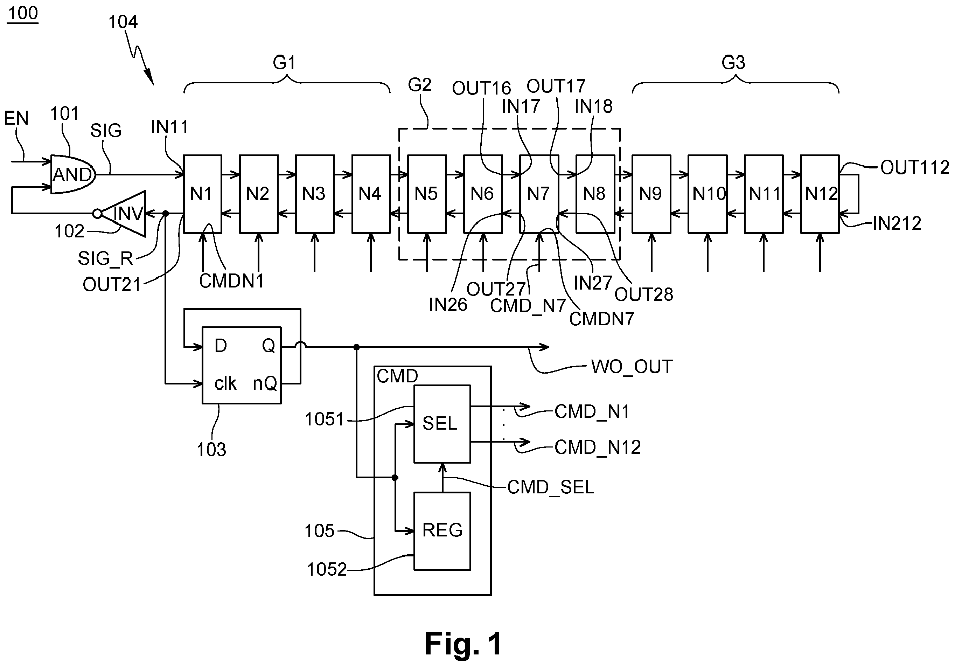

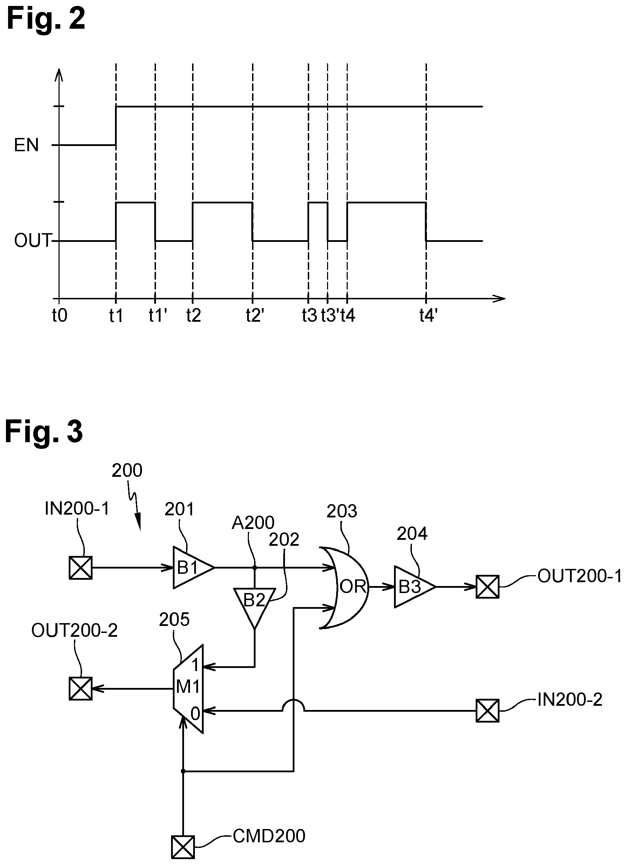

La figure 1 représente, de façon schématique et sous forme de blocs, un mode de réalisation d'un dispositif adapté à générer un signal numérique vobulé, ou générateur d'un signal numérique vobulé 100. Le fonctionnement du générateur 100 est décrit plus en détails en relation avec la figure 2.
Le générateur 100 comprend, en entrée, une porte logique de type ET 101 (AND), ou porte ET 101, ayant, par exemple, deux entrées suiveuses, et une sortie. La porte 101 reçoit sur une de ses entrées suiveuses un signal d'activation EN, et fournit un signal numérique SIG sur sa sortie. Selon une variante, la porte 101 comprend une entrée inverseuse et une entrée suiveuse.
Le générateur 100 comprend, en outre, une porte inverseuse 102 (INV) comprenant une entrée et une sortie. La sortie de la porte 102 est reliée, de préférence connectée, à l'entrée suiveuse de la porte ET 101. La porte inverseuse 102 reçoit, en entrée, le signal SIG retardé noté SIG_R.
Le générateur 100 comprend, en outre, une bascule de type D 103, comprenant une entrée de donnée D, une entrée d'horloge clk, une sortie Q et une sortie inverseuse nQ. L'entrée de donnée D est reliée, de préférence connectée, à la sortie inverseuse nQ de la bascule 103. L'entrée d'horloge clk est reliée, de préférence connectée, à l'entrée de la porte inverseuse 102, et reçoit donc le signal retardé SIG_R. La sortie Q fournit un signal numérique vobulé de sortie WO_OUT.
Comme dit précédemment, un signal numérique vobulé est un signal oscillant dont la fréquence, et en conséquence la période, varie au cours du temps. Plus particulièrement, un signal numérique vobulé peut être un signal de forme sensiblement créneau ayant un rapport cyclique sensiblement constant, par exemple constant, et dont la fréquence, et donc la période, varie dans le temps. Selon un exemple, la période d'un signal numérique vobulé est modifiée à chaque nouveau front montant ou descendant du signal. Selon une variante, la période d'un signal numérique vobulé peut être modifiée après un nombre aléatoire de fronts montants ou descendants. On définit, pour la suite de la description que la période d'un signal numérique vobulé est la durée entre deux fronts montants successifs du signal numérique vobulé.

Le générateur 100 comprend, en outre, une chaine 104 d'éléments activables adaptés à retarder le signal numérique SIG pour fournir le signal SIG_R. La chaine 104 peut aussi être appelée une série ou une liste d'éléments adaptés à retarder un signal numérique. Les éléments activables adaptés à retarder un signal numérique, ou éléments de retard dans la suite de la description, sont un ou un assemblage de composants adaptés à ajouter un retard temporel à un signal numérique quand ils sont activés, et à ne pas ajouter de retard temporel audit signal quand ils ne sont pas activés. Un exemple de réalisation d'un élément de retard est décrit en relation avec la figure 3. Selon un exemple, tous les éléments de retard de la chaine 104 sont adaptés à ajouter une même durée de retard, appelé ci-après retard, à un signal numérique, mais selon une variante, chaque élément de retard de la chaine 104 peut être adapté à ajouter un retard différent.

En figure 1 et pour ne pas surcharger la figure, la chaine 104 comprend douze éléments N1 à N12. Cependant de façon générale, la chaine 104 peut comprendre un nombre K d'éléments de retards, K étant un nombre entier compris, par exemple, entre 12 et 40, par exemple égale à 16 ou 32. Chaque élément de retard $N_i$, $i$ étant un entier variant de 1 à 12, ou de 1 à K, comprend deux entrées $IN1_i$ et $IN2_i$, deux sorties $OUT1_i$ et $OUT2_i$, et une borne de commande $CMDN_i$ recevant un signal de commande $CMD\_N_i$.

Pour former la chaine 104, les éléments de retard N1 à N12 sont reliés "en série", c'est-à-dire que les éléments N1 à N12 sont reliés les uns aux autres pour former une ligne. Plus particulièrement, chaque élément $N_i$ a :

- son entrée $IN1_i$ reliée, de préférence connectée, à la sortie $OUT1_{i-1}$ de l'élément $N_{i-1}$ de rang précédent ;
- sa sortie $OUT1_i$ reliée, de préférence connectée, à l'entrée $IN1_{i+1}$ de l'élément $N_{i+1}$ de rang suivant ;
- son entrée $IN2_i$ reliée, de préférence connectée, à la sortie $OUT2_{i+1}$ de l'élément $N_{i+1}$ de rang suivant ; et
- sa sortie $OUT2_i$ reliée, de préférence connectée, à l'entrée $IN2_{i-1}$ de l'élément $N_{i-1}$ de rang précédent.

L'élément de retard de rang 1 de la chaine 104, c'est-à-dire le premier élément de retard de la chaine 104, c'est-à-dire l'élément N1 en figure 1, a son entrée $IN1_1$ reliée, de préférence connectée, à la sortie de la porte ET 101, et reçoit donc le signal numérique SIG. De plus, l'élément de retard N1 a sa sortie $OUT2_1$ reliée, de préférence connectée, à l'entrée de la porte inverseuse 102 et à l'entrée d'horloge clk de la bascule 103, et fournit donc le signal retardé SIG_R. De plus, l'élément de retard de rang maximal, c'est-à-dire le dernier élément de retard de la chaine 104, c'est-à-dire l'élément N12 en figure 1, a sa sortie $OUT1_{12}$ reliée, de préférence connectée, à sa propre entrée $IN2_{12}$.

Selon un mode de réalisation, les éléments de retard N1 à N12 de la chaine 104 sont repartis en trois groupes d'éléments de retard, parmi lesquels :

- un groupe G1 d'éléments de retard (premiers éléments) activés, ou actifs, par leurs signaux de commande ;
- un groupe G2 d'éléments de retard (deuxièmes éléments) activables par leurs signaux de commande ; et
- un groupe G3 d'éléments de retard (troisièmes éléments) désactivés, ou non actifs, par leur signaux de commande.

Plus particulièrement, le groupe G1 comprend k1 éléments de retard disposés en début de la chaine 104. Autrement dit, le groupe G1 comprend les k1 premiers éléments de retard de la chaine 104, c'est-à-dire les k1 éléments de retard dont le rang est compris entre 1 et k1. En figure 1, k1 vaut quatre, et le groupe G1 comprend les éléments N1 à N4.

Plus particulièrement, le groupe G2 comprend k2 éléments de retard disposés en milieu de la chaine 104. Autrement dit, le groupe G2 comprend les k2 éléments de retard disposés entre les éléments du groupe G1 et les éléments du groupe G3, c'est-à-dire les k2 éléments de retard dont le rang est compris entre k1+1 et kl+k2. En figure 1, k2 vaut quatre, et le groupe G2 comprend les éléments N5 à N8. On peut appeler le groupe G2 la fenêtre de travail du générateur 100.

Plus particulièrement, le groupe G3 comprend k3 éléments de retard disposés en fin de la chaine 104. Autrement dit, le groupe G3 comprend les k3 derniers éléments de retard de la chaine 104, c'est-à-dire les k3 éléments de retard dont le rang est compris entre k1+k2+1 et k1+k2+k3. En figure 1, k3 vaut quatre, et le groupe G3 comprend les éléments N9 à N12.

Le générateur 100 comprend, en outre, un circuit de commande 105 (CMD) adapté à commander les éléments de retard de la chaine 104. Le circuit 105 comprend une entrée recevant le signal numérique vobulé de sortie WO_OUT, et autant de sortie que d'éléments de retard de la chaine 104 fournissant les signaux de commande CMD_N1, ..., CMD_N12 aux éléments de retard. Autrement dit, l'entrée du circuit de commande 105 est reliée, de préférence connectée, à la sortie Q de la bascule 103, et chaque sortie du circuit de commande est reliée, de préférence connectée, à une borne $CMDN_i$ d'un élément $N_i$ de la chaine 104.

Le circuit de commande 105 comprend une unité de sélection 1051 (SEL) et une unité de régulation 1052 (REG).

L'unité de sélection 1051 est utilisée pour modifier le nombre d'éléments de retard activés de la chaine 104.

L'unité de sélection reçoit le signal WO_OUT, un signal de commande CMD_SEL, et fournit les signaux de commande CMD_N1, ..., CMD_N12 aux éléments de retard. Plus particulièrement, et comme cela est décrit plus en détails en relation avec la figure 2, l'unité de sélection 1051 est adaptée à modifier le nombre d'éléments de retard activés de la chaine 104 périodiquement, par exemple à chaque nouveau front montant du signal de sortie WO_OUT.

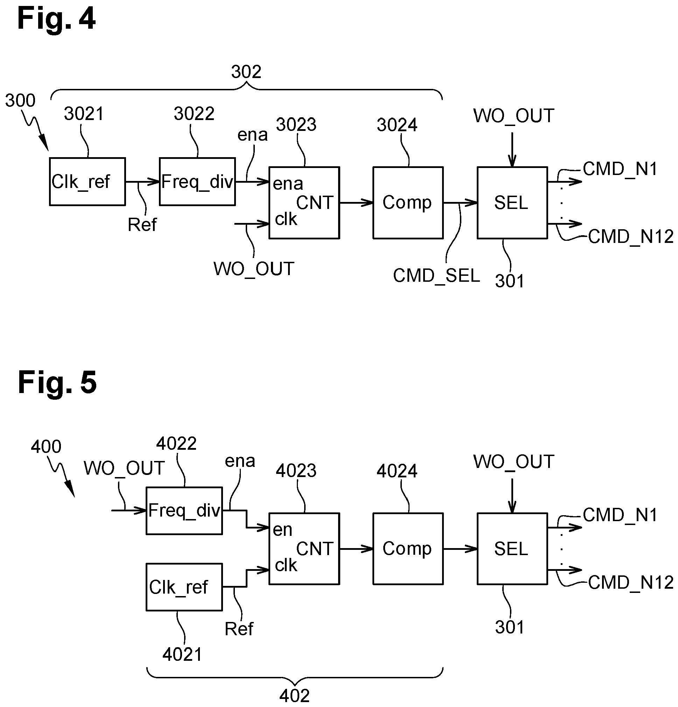

L'unité de régulation 1052 est utilisée pour vérifier que la fréquence moyenne Fmoy, ou de la même façon que la période moyenne Pmoy, du signal de sortie WO_OUT est égal à une fréquence moyenne centrale visée Fcentrale, ou fréquence de référence, ou de la même façon à une période centrale visée Pcentrale, en comparant la fréquence moyenne Fmoy à la fréquence centrale Fcentrale, et à fournir un signal de commande CMD_SEL permettant de corriger ladite fréquence moyenne le cas échéant. Pour cela, l'unité de régulation 1052 reçoit le signal WO_OUT et fournit le signal de commande CMD_SEL à l'unité de sélection 1051. Des exemples de réalisation de l'unité de régulation 1051 sont décrits en relation avec les figures 4 et 5.

Le circuit de commande 105 comprend deux modes de fonctionnement, un mode normal de fonctionnement et un mode de régulation. Le mode normal de fonctionnement est décrite en relation avec la figure 2, et le mode de régulation est décrit ensuite. Le mode de régulation peut être mis en oeuvre régulièrement, par exemple périodiquement, ou alors ponctuellement.

Un avantage du générateur 100 est qu'il n'est pas, ou peu affecté, par les phénomènes de verrouillage. En effet, le générateur 100 étant capable de modifier sa fréquence, est capable d'empêcher la mise en place d'un phénomène de verrouillage.

La figure 2 représente deux chronogrammes illustrant le fonctionnement dans un mode normal de fonctionnement du circuit de commande 105 du générateur 100 décrit en relation avec la figure 1. Plus particulièrement, la figure 2 représente un chronogramme du signal d'activation EN et du signal de sortie WO_OUT du générateur 100.

Entre un instant initial t0 et un instant t1, postérieur à l'instant t0, le signal EN est à un état bas et le générateur 100 n'est pas démarré. Le signal SIG est alors à un état bas. Le signal SIG_R ne présente pas de front montant permettant de faire basculer le signal de sortie WO_OUT en sortie de la bascule 103, donc le signal WO_OUT est à un niveau bas. Le signal en sortie de la porte inverseuse 102 est quand à lui à un état haut.

A partir de l'instant t1, le générateur 100 démarre, et le signal EN passe à un niveau haut. Le signal SIG passe à un niveau haut et le signal SIG_R se met alors à osciller à une fréquence définie par le nombre d'éléments de retard activés dans la chaine 104 par l'unité de sélection 1051. Plus particulièrement, l'unité de sélection 1051 active tous les éléments de retard du groupe G1, c'est-à-dire k1 éléments de retard, et sélectionne un nombre k2(1) d'éléments de retard parmi le groupe G2, k2(1) étant inférieur à k2, et les active également. Le retard accumulé par le signal traversant la chaine 104 est définie par la somme des retards imposés par les éléments de retard de la chaine 104 activés. Dans le cas où tous les éléments de retard permettent d'ajouter un même retard R, le retard accumulé par le signal SIG_R est égal à (k1+k2(1))*R, c'est-à-dire le retard R multiplié par la somme des nombres k1 et k2(1). Il est à noter que le retard minimal ajouté par la chaine 104 est le retard ajouté par les éléments de retard du groupe G1, et que le retard maximal est le retard ajouté par les éléments de retard du groupe G1 et tous les éléments de retard du groupe G2.

La bascule 105 reçoit sur son entrée d'horloge clk le signal SIG_R oscillant, et fournit en sortie le signal oscillant vobulé WO_OUT. Le signal WO_OUT change d'état à chaque fois que le signal SIG_R présente un front montant. Plus particulièrement, à l'instant t1, le signal WO_OUT passe d'un niveau bas à un niveau haut car le signal en sortie de la chaine 104 présente un front montant. A un instant t1', successif à l'instant t1, le signal WO_OUT passe du niveau haut au niveau bas, car le signal SIG_R présente un front montant.

A un instant t2, successif à l'instant t1', le signal WO_OUT a effectué une période complète à la fréquence imposée par la chaine 104. Plus particulièrement, le signal WO_OUT est passé à un niveau haut pendant la durée (k1+k2(1))*R, puis à un niveau bas pendant cette même durée (k1+k2(1))*R, lorsque tous les éléments de retard ajoutent un même retard R. L'unité de sélection modifie les signaux de commande pour activer un nombre k2(2) d'éléments de retard du groupe G2 et non plus k2(1) d'éléments de retard. Le nombre k2(2) est inférieur au nombre k2, et est, de préférence, différent du nombre k2(1). A un instant t2', successif à l'instant t2, le signal WO_OUT passe du niveau haut au niveau bas, car le signal SIG_R présente un nouveau front montant.

A un instant t3, successif à l'instant t2', le signal OUT a effectué une nouvelle période complète, ainsi l'unité de sélection 1051 modifie les signaux de commande pour activer un nombre k2(3) d'éléments de retard du groupe G2. Le nombre k2(3) est inférieur au nombre k2, et est, de préférence, différent du nombre k2(2). A un instant t3', successif à l'instant t3, le signal WO_OUT passe du niveau haut au niveau bas, car le signal SIG_R présente un nouveau front montant.

A un instant t4, successif à l'instant t3', le signal WO_OUT a effectué une nouvelle période complète, ainsi le circuit de commande modifie les signaux de commande pour activer un nombre k2(4) d'éléments de retard du groupe G2. Le nombre k2(4) est inférieur au nombre k2, et k2(4) est, de préférence, différent du nombre k2(3). A un instant t4', successif à l'instant t4, le signal OUT passe du niveau haut au niveau bas, car le signal SIG_R présente un nouveau front montant.

Le mode de fonctionnement normal continue ainsi de suite pour fournir le signal numérique vobulé WO_OUT.

Le mode de régulation du circuit de commande 105 du générateur 100 de la figure 1 est maintenant décrit. Dans ce mode, l'unité de régulation 1052 a détecté que, pendant une certaine durée, la fréquence moyenne Fmoy du signal de sortie WO_OUT est différente de la fréquence centrale visée Fcentrale, ou que la période moyenne Pmoy est différente de la période centrale visée Pcentrale. L'unité de régulation 1052 commande alors l'unité de sélection 1051 pour qu'elle modifie le nombre d'éléments compris dans les groupes G1, G2 et/ou G3 pour le prochain mode normal de fonctionnement. Selon un mode de réalisation préféré, dans ce cas, l'unité de sélection 1051 ne modifie que les nombres k1 et k3 d'éléments de retard des groupes G1 et G3, et laisse le nombre k2 inchangé de façon à "décaler" le groupe G2 dans la chaine 104, ou à "décaler la fenêtre de travail" du générateur 100. Selon un autre mode de réalisation, dans ce cas l'unité de sélection 1051 modifie les nombres k1, k2 et k3, et modifie ainsi la répartition totale des éléments de retard dans les groupes G1, G2 et G3.

Plus particulièrement, quand l'unité de régulation 1052 détecte que la fréquence moyenne Fmoy du signal de sortie est supérieure à la fréquence centrale visée Fcentrale, l'unité de régulation 1052 demande à l'unité de sélection 1051 d'augmenter le nombre k1 d'éléments de retard toujours activés du groupe G1, et de réduire le nombre k3 d'éléments de retard toujours désactivés du groupe G3. Selon un exemple, le nombre k2 d'éléments de retard du groupe G2 est inchangé ou est modifié. En effet, si la fréquence moyenne Fmoy est supérieure à la fréquence centrale visée Fcentrale, alors le signal est "trop rapide", et doit être ralenti dans sa globalité. Pour cela on augmente de manière globale le retard ajouté au signal de sortie WO_OUT.

A l'inverse, quand l'unité de régulation 1052 détecte que la fréquence moyenne Fmoy du signal de sortie est supérieure à la fréquence centrale visée Fcentrale, l'unité de régulation 1052 demande à l'unité de sélection 1051 de réduire le nombre k1 d'éléments de retard toujours activés du groupe G1, et d'augmenter le nombre k3 d'éléments de retard toujours désactivés du groupe G3. Selon un exemple, le nombre k2 d'éléments de retard du groupe G2 est inchangé ou est modifié. En effet, si la fréquence moyenne Fmoy est inférieure à la fréquence centrale visée Fcentrale, alors le signal est "trop lent", et doit être accéléré dans sa globalité. Pour cela on réduit de manière globale le retard ajouté au signal de sortie WO_OUT.

La quantification des modifications des nombres k1, k2 et k3 peut être réalisé de différentes manières, dont certaines sont décrites en relation avec les figures 4 et 5.

La figure 3 est un schéma électrique d'un exemple de réalisation d'un élément de retard 200 du type d'un élément de retard de la chaine 104 du générateur 100 décrit en relation avec la figure 1.

Comme décrit précédemment, l'élément de retard 200 comprend deux entrées IN200-1 et IN200-2, deux sorties OUT200-1 et OUT200-2, et une borne de commande CMD200.

L'élément de retard 200 comprend un premier dispositif tampon 201 (B1) (buffer en anglais), ou amplificateur séparateur 201, comprenant une entrée et une sortie, et adapté à ajouter un retard à un signal numérique. L'entrée du dispositif tampon 201 est reliée, de préférence connectée, à l'entrée IN200-1, et sa sortie est reliée, de préférence connectée à un noeud A200. Le dispositif tampon 201 est optionnel.

L'élément de retard 200 comprend, en outre, un deuxième dispositif tampon 202 (B2), ou amplificateur séparateur 202, comprenant une entrée et une sortie, et adapté à ajouter un retard à un signal numérique. L'entrée du dispositif tampon 202 est reliée, de préférence connectée, au noeud A200. Le dispositif tampon 202 est optionnel.

L'élément de retard 200 comprend, en outre, une porte logique de type OU 203 (OR), ou porte OU 203, comprenant deux entrées suiveuses et une sortie. Une première entrée de la porte 203 est reliée, de préférence connectée, au noeud A200, et une deuxième entrée de la porte 203 est reliée, de préférence connectée, à la borne de commande CMD200.

L'élément de retard 200 comprend, en outre, un troisième dispositif tampon 204 (B3), ou amplificateur séparateur 204, comprenant une entrée et une sortie, adapté à ajouter un retard à un signal numérique. L'entrée du dispositif tampon 204 est reliée, de préférence connectée, à la sortie de la porte OU 203, et sa sortie est reliée, de préférence connectée à la sortie OUT200-1. Le dispositif tampon 204 est optionnel.

L'élément de retard 200 comprend, en outre, un multiplexeur 205 (M1) comprenant deux entrées, une sortie, et une borne de commande. La borne de commande est reliée, de préférence connectée, à la borne de commande CMD200 de l'élément de retard 200. Une première entrée (1) sélectionnée lorsque le signal de commande est à un état haut, est reliée, de préférence connectée, à la sortie du dispositif tampon 202. Une deuxième entrée (0), sélectionnée lorsque le signal de commande est à un état bas est reliée, de préférence connectée, à l'entrée IN200-2 de l'élément de retard 200. La sortie est reliée, de préférence connectée, à la sortie OUT200-2 de l'élément de retard 200.

Le fonctionnement de l'élément de retard est le suivant. Lorsque l'élément de retard est activé, un signal reçu sur l'entrée IN200-2 doit être fourni sur la sortie OUT200-2 avec un certain retard. Lorsque l'élément de retard est désactivé, un signal reçu sur l'entrée IN200-1 doit être fourni sur la sortie OUT200-2 sans retard.

Plus particulièrement, quand l'élément de retard est désactivé, l'élément de retard reçoit sur sa borne de commande CMD200 un signal de commande à un état bas. Le signal fourni par la sortie de la porte OU 203 est égal au signal reçu par l'entrée IN200-1. L'élément de retard 200 fournit sur sa sortie OUT200-1 un signal retardé par les dispositifs tampon 201 et 204. Comme décrit en figure 1, l'élément de retard 200 peut faire partie d'une chaine d'éléments de retard où les éléments de retard sont reliés en série. Ainsi la sortie OUT200-1 est soit reliée à une entrée d'un autre élément de retard, soit reliée à l'entrée IN200-2 de l'élément 200. Le signal reçu par l'entrée IN200-2 est fourni à la sortie OUT200-2, puisque le multiplexeur fournit en sortie le signal qu'il a reçu sur sa deuxième entrée (0).

Plus particulièrement, quand l'élément de retard est désactivé, l'élément de retard reçoit sur sa borne de commande CMD200 un signal de commande à un état haut. Le multiplexeur 205 fournit sur sa sortie le signal qu'il reçoit sur sa première entrée (1), c'est-à-dire le signal fourni en sortie du dispositif tampon 202. De plus, dans ce cas la sortie de la porte OU 203 est toujours à un état haut.

La figure 4 représente, schématiquement et sous forme de blocs, un exemple de réalisation d'un circuit de commande 300 du type du circuit de commande 105 du générateur 100 décrit en relation avec la figure 1.

Comme décrit en relation avec la figure 1, le circuit de commande 300 comprend une unité de sélection 301, du type de l'unité de sélection 1051, et une unité de régulation 302, du type de l'unité de régulation 1052.

L'unité de sélection 301 reçoit, en entrée, le signal numérique vobulé WO_OUT de sortie du générateur dont le circuit de commande fait partie, et un signal de commande CMD_SEL provenant de l'unité de régulation 301. L'unité de commande fournit, en sortie, les signaux de commande CMD_N1, ... CMD_N12 des éléments de retard de la chaine à laquelle le circuit de commande est associé.

L'unité de régulation 302 reçoit, en entrée, le signal numérique vobulé WO_OUT de sortie, et fournit, à l'unité de sélection 301, le signal de commande CMD_SEL.

L'unité de régulation 302 comprend :

- un générateur 3021 (Clk_ref) d'un signal d'horloge à fréquence fixe ;
- un circuit diviseur de fréquence 3022 (Freq_div) ;
- un compteur 3023 (CNT) ; et
- un circuit de compensation 3024 (Comp).

Le générateur 3021 est adapté à fournir un signal d'horloge de référence Ref. Selon un exemple, le générateur 3021 est une boucle à verrouillage de phase (PLL, de l'anglais Phase-locked loop).

Le circuit diviseur de fréquence 3022 permet de commander l'activation du compteur 3023. Le circuit diviseur de fréquence reçoit le signal d'horloge de référence Ref, et fournit un signal d'activation ena du compteur 3023. Plus particulièrement, le circuit diviseur de fréquence 3022 détermine la durée du mode de régulation, en mettant le signal d'activation ena à un état haut pendant ladite durée, et à un état bas sinon.

Le compteur 3023 comprend une entrée d'activation ena et une entrée d'horloge clk, et une sortie. L'entrée d'activation ena reçoit le signal d'activation ena, et l'entrée d'horloge reçoit le signal de sortie WO_OUT. Le compteur fournit, en sortie, un signal numérique représentatif d'un résultat de comptage. Le compteur 3023 est adapté à compter, pendant une certaine durée, ou fenêtre de calcul, le nombre de fronts montants du signal qu'il reçoit sur son entrée d'horloge, donc le signal de sortie WO_OUT. Le résultat de ce comptage est fourni en sortie.

Le circuit de compensation 3024 comprend une entrée recevant le signal de sortie du compteur 3023, et une sortie fournissant le signal de commande CMD_SEL.

Deux modes de réalisation sont décrits ci-après et prennent les mêmes postulats. Un premier postulat est que le nombre k2 d'éléments de retard du groupe G2 n'est jamais modifié. Un deuxième postulat est que les éléments de retard de la chaine du générateur ajoutent tous le même retard et que le signal de commande CMD_SEL est un signal représentant un nombre relatif H qui est à ajouter aux nombres k1 et k3 pour réguler le générateur 100, aussi appelé commande de régulation H..

Selon un premier mode de réalisation, le circuit de compensation établit le nombre H en utilisant la formule suivante :

[Math 1]

$$H = \frac{\left(\dfrac{C}{Rf} - \dfrac{C}{M}\right)}{S}$$

dans laquelle :

- C représente la durée pendant laquelle le compteur effectue son calcul ;
- Rf représente le nombre de fronts montants de référence ;
- M représente la valeur mesurée par le compteur 3023 pendant la durée C ; et
- S représente la durée d'un retard d'un élément de retard.

Un avantage est qu'en régulant le générateur en utilisant la formule de ce premier mode de réalisation, le signal est régulé en une seule itération.

Selon un deuxième mode de réalisation, le circuit de compensation établit le nombre H en utilisant la formule suivante :

[Math 2]

$$H = (M - Rf) * K$$

dans laquelle :

- M et Rf ont déjà été définis ci-dessus ; et
- K est une constante d'approximation linéaire dépendant des variables Rf, M, C et S définies ci-dessus.

Selon un exemple, la constante K peut être définie par la formule mathématique suivante :

[Math 3]

$$K = \frac{C * S}{Rf * M}$$

Un avantage de ce deuxième mode de réalisation par rapport au premier mode de réalisation est qu'il est plus facile à implémenter.

D'autres méthodes de calcul et d'optimisation de la régulation sont à la portée de la personne du métier.

La figure 5 représente, schématiquement et sous forme de blocs, un exemple de réalisation d'un circuit de commande 400 du type du circuit de commande 105 du générateur 100 décrit en relation avec la figure 1.

Le circuit de commande 400 présente des éléments communs avec le circuit de commande 300 décrit en relation avec la figure 1. Ces éléments ne sont pas décrits de nouveau en détails, et seules les différences entre les circuits de commande 300 et 400 sont mises en exergue.

Ainsi, le circuit de commande 400 comprend l'unité de sélection 301 et une unité de régulation 402, du type de l'unité de régulation 1052.

L'unité de régulation 402 reçoit, en entrée, le signal numérique vobulé WO_OUT de sortie, et fournit, à l'unité de sélection 301, le signal de commande CMD_SEL.

L'unité de régulation 402 comprend des éléments similaires à l'unité de régulation 302 du circuit de commande 300, mais qui sont agencés de manière différente. L'unité de régulation 402 comprend :

- un générateur 4021 (Clk_ref) d'un signal d'horloge à fréquence fixe ;
- un circuit diviseur de fréquence 4022 (Freq_div) ;
- un compteur 4023 (CNT) ; et
- un circuit de compensation 4024 (Comp).

Le générateur 4021 est adapté à fournir un signal d'horloge de référence Ref. Selon un exemple, le générateur 4021 est une boucle à verrouillage de phase (PLL, de l'anglais Phase-locked loop).

Le circuit diviseur de fréquence 4022 permet de commander l'activation du compteur 4023. Le circuit diviseur de fréquence reçoit le signal de sortie WO_OUT, et fournit un signal d'activation ena du compteur 4023. Plus particulièrement, le circuit diviseur de fréquence 3022 détermine la durée du mode de régulation, en mettant le signal d'activation ena à un état haut pendant ladite durée, et à un état bas sinon.

Le circuit diviseur de fréquence reçoit en entrée le signal de sortie WO_OUT et fournit un signal de référence WO_OUT'.

Le compteur 4023 comprend une entrée d'activation ena et une entrée d'horloge clk, et une sortie. L'entrée d'activation ena reçoit le signal de référence WO_OUT', et l'entrée d'horloge reçoit le signal de référence Ref. Le compteur fournit, en sortie, un signal numérique représentatif d'un résultat de comptage. Le compteur 4023 est adapté à compter, pendant une certaine durée, ou fenêtre de calcul, le nombre de fronts montants du signal qu'il reçoit sur son entrée d'horloge, donc le signal de référence Ref. Le résultat de ce comptage est fourni en sortie.

Le circuit de compensation 4024 comprend une entrée recevant le signal de sortie du compteur 4023, et une sortie fournissant le signal de commande CMD_SEL.

Selon un mode de réalisation, un premier postulat est que le nombre k2 d'éléments de retard du groupe G2 n'est jamais modifié. Un deuxième postulat est que les éléments de retard de la chaine du générateur ajoutent tous le même retard et que le signal de commande CMD_SEL est un signal représentant un nombre relatif H qui est à ajouter aux nombres k1 et k3 pour réguler le générateur 100.

Le circuit de compensation 4024 établit le nombre H en utilisant la formule suivante :

[Math 4]

$$H = (Rf - M)\frac{T\_clk\_ref}{2 * S * DIV}$$

dans laquelle :

- Rf représente le nombre de fronts montants de référence ;
- M représente le nombre de fronts montants du signal Ref relevé par le compteur 4023 pendant la durée C ;
- S représente la durée d'un retard d'un élément de retard ;
- T_clk_ref représente la période du signal de référence Ref ; et
- DIV représente le nombre de fronts montants relevé par un circuit diviseur de fréquence 4023.

Un avantage est qu'en régulant le générateur en utilisant la formule de ce mode de réalisation, le signal est régulé en une seule itération.

Un autre avantage de ce mode de réalisation par rapport au premier mode de réalisation est qu'il est plus facile à implémenter.

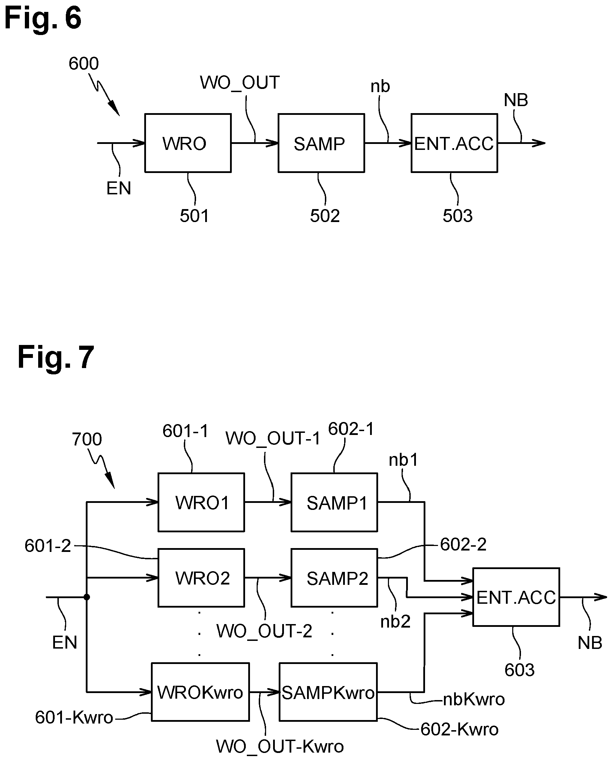

La figure 6 est un schéma illustrant, schématiquement et sous forme de blocs, un mode de réalisation d'un générateur de nombres aléatoires 500.

Le générateur 500 comprend :

- un générateur 501 (WRO) d'un signal numérique vobulé du type du générateur 100 décrit en relation avec les figures 1 et 2 ;
- un circuit d'échantillonnage 502 (SAMP) ; et
- un circuit 503 (ENT. ACC) mettant en oeuvre une fonction d'accumulation d'entropie.

Le générateur de signal numérique vobulé 501 reçoit, en entrée, le signal d'activation EN et fournit, en sortie, le signal numérique vobulé WO_OUT, selon le fonctionnement décrit en relation avec la figure 1.

Le circuit d'échantillonnage 502 reçoit, en entrée, le signal WO_OUT et fournit, en sortie, un bit de donnée représentant un nombre aléatoire nb. Selon un exemple de réalisation, le circuit 502 peut comprendre une bascule de type D et un circuit générant un signal d'horloge.

Le circuit 503 est un circuit mettant en oeuvre une fonction d'accumulation d'entropie, c'est-à-dire une fonction prenant une ou plusieurs entrées et dont l'unique sortie conserve l'entropie des entrées. Autrement dit, si au moins une des entrées est aléatoire, la sortie de la fonction est aléatoire également. Selon un exemple de réalisation, le circuit 503 peut mettre en oeuvre une fonction logique OU EXCLUSIF (XOR). Le circuit 503 reçoit, en entrée, le nombre aléatoire nb et fournit, en sortie, un bit de donnée représentant un nombre aléatoire NB.

Le fonctionnement du générateur de nombres aléatoires 500 est le suivant. Le générateur de signal vobulé génère le signal WO_OUT qui est ensuite échantillonné par le circuit 502 pour fournir le nombre aléatoire nb. Ce nombre aléatoire nb passe ensuite par la fonction d'accumulation d'entropie pour donner le nombre NB. A titre d'exemple, la fonction d'accumulation d'entropie peut enregistrer successivement plusieurs nombres aléatoires nb générés les uns après les autres pour produire le nombre NB.

La figure 7 est un schéma illustrant, schématiquement et sous forme de blocs, un autre mode de réalisation d'un générateur de nombres aléatoires 600.

Le générateur 600 comprend :

- Kwro générateurs 601-j (WRO1, WRO2, ..., WROKwro), j variant de 1 à Kwro, d'un signal numérique vobulé du type du générateur 100 décrit en relation avec les figures 1 et 2 ;
- Kwro circuits d'échantillonnage 602-j (SAMP1, SAMP2, ..., SAMPKwro) ; et
- un circuit 603 (ENT. ACC) mettant en oeuvre une fonction d'accumulation d'entropie.

Les générateurs 601-j sont disposés en parallèle les uns des autres. Chaque générateur 601-j reçoit, en entrée, le signal d'activation EN et fournit, en sortie, un signal numérique vobulé WO_OUTj, selon le fonctionnement décrit en relation avec la figure 1.

Les circuits d'échantillonnage 602-j sont disposés en parallèle les uns des autres, et en sortie de chaque générateur 601-j. Chaque circuit d'échantillonnage 602-j reçoit, en entrée, le signal WO_OUTj et fournit, en sortie, un bit de donnée représentant un nombre aléatoire nbj. Selon un exemple de réalisation, chaque circuit 602-j peut comprendre une bascule de type D reliée à un circuit, par exemple commun à tous les circuits 602-j, générant un signal d'horloge.

Le circuit 603 est un circuit mettant en oeuvre une fonction d'accumulation d'entropie, du type du circuit 503 décrit en relation avec la figure 6. Le circuit 603 comprend Kwro entrées recevant chacune un nombre aléatoire nbj, et une sortie fournissant le nombre aléatoire NB. Selon un exemple de réalisation, le circuit 603 peut mettre en oeuvre une fonction logique OU EXCLUSIF (XOR). Selon un autre exemple, la fonction d'accumulation peut être une fonction de compression.

Le fonctionnement du générateur de nombres aléatoires 600 est le suivant. Les générateurs de signal vobulé 601-j génèrent, tous en parallèle, un signal WO_OUTj. Chaque signal WO_OUTj est ensuite échantillonné par le circuit 602-j pour fournir le nombre aléatoire nbj. Le circuit 603 utilise les nombres aléatoires nbj comme entrée pour fournir le nombre aléatoire final NB.

Le nombre Kwro de générateurs de signal vobulé peut être compris entre 2 et 50. Le choix du nombre Kwro se fixe en jouant sur le compromis encombrement et rapidité du générateur de nombres aléatoires. En effet, plus le nombre Kwro est grand, plus le générateur 600 pourra fournir un nombre aléatoire NB rapidement, mais plus son nombre de composants électroniques augmente et donc sa taille physique augmente.

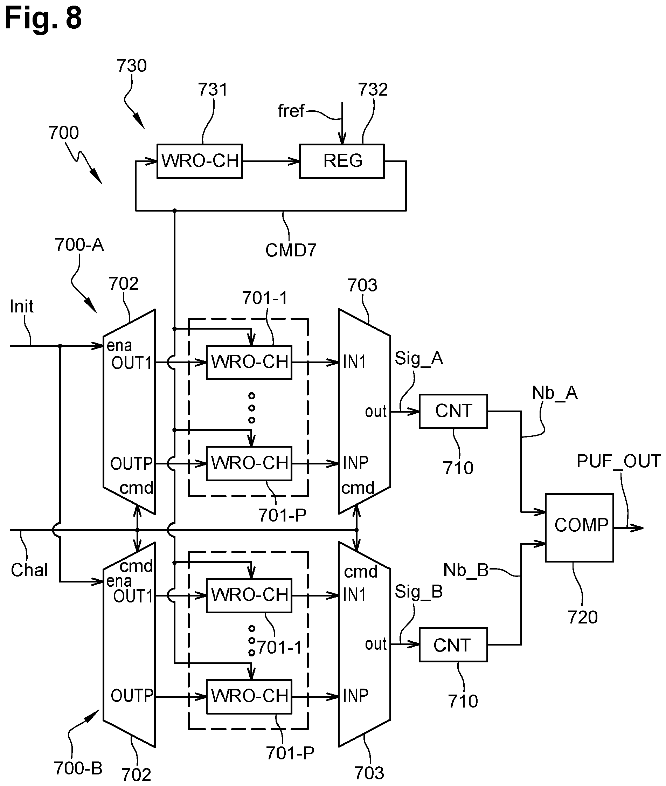

La figure 8 est un schéma illustrant, schématiquement et sous forme de blocs, un mode de réalisation d'un dispositif 700 adapté à mettre en oeuvre une fonction physique inclonable (Physical Unclonable Function, PUF), c'est-à-dire une fonction dont le résultat est unique et inclonable pour chaque dispositif la mettant en oeuvre. Ce type de fonction peut être utilisé pour l'identification de dispositifs électroniques, ou pour la génération de données pouvant servir de clé intrinsèque.

Le dispositif 700 comprend deux circuits 700-A et 700-B de génération de deux signaux numériques Sig-A et Sig-B. Selon un mode de réalisation, les circuits 700-A et 700-B sont identiques aux différences liées au procédé de fabrication près. Le dispositif 700 comprend, en outre, un compteur 710-A (CNT) adapté à recevoir le signal Sig-A et un compteur 710-B (CNT) adapté à recevoir le signal Sig-B et à compter, par exemple, leur nombre d'états hauts pendant une durée donnée. Selon un mode de réalisation, les compteurs 710-A et 710-B sont identiques aux différences liées au procédé de fabrication près. Le compteur 710-A, respectivement 710-B, fournit en sortie un signal représentant un nombre Nb-A, respectivement Nb-B. Le dispositif 700 comprend, en outre, un comparateur 720 (COMP) adapté à recevoir et à comparer les signaux Nb-A et Nb-B pour fournir en sortie un signal PUF_OUT représentant la sortie de la fonction physique inclonable. Selon un exemple, le signal PUF_OUT représente un nombre.

Les circuits 700-A et 700-B comprennent chacun P générateurs de signaux vobulés 701-1, ..., 701-P (WRO-CH) disposés en parallèle les uns des autres entre un circuit de sélection d'entrée 702, par exemple un multiplexeur d'entrée, et un circuit de sélection de sortie 703, par exemple un multiplexeur de sortie.

Plus particulièrement, chaque générateur de signal vobulé 701-1, ..., 701-P est un générateur d'un signal vobulé du type de celui décrit en relation avec la figure 1, à la différence que tous les générateurs de signaux vobulés 701-1, ..., 701-P, c'est-à-dire les générateurs de signaux vobulés des circuits 700-A et 700-B, ont un circuit de commande ne présentant pas de circuit de régulation mais seulement une borne d'entrée permettant au circuit de sélection du circuit de commande de recevoir un signal de commande CMD7, du type du signal de commande CMD-SEL décrit en relation avec la figure 1. Autrement dit, les générateurs 701-1, ..., 701-P comprennent uniquement :

- une porte logique de type ET du type de la porte 101 décrite en relation avec la figure 1 ;
- une porte logique de type inverseuse du type de la porte 102 décrite en relation avec la figure 1 ;
- une bascule du type de la bascule 103 décrite en relation avec la figure 1 ;
- une chaine d'éléments de retard du type de la chaine 103 décrite en relation avec la figure 1 ; et
- un circuit de commande du type du circuit de commande 105 décrit en relation avec la figure 1, mais ne comprenant qu'un circuit de sélection du type du circuit de sélection 1051, et une borne d'entrée adapté à recevoir le signal de commande CMD7.

De plus, chaque circuit de sélection d'entrée 702 comprend une entrée ena et P sorties OUT1, ..., OUTP. L'entrée reçoit un signal d'activation Init, et chaque sortie est reliée à une entrée d'un des générateurs de signaux vobulés 701-1, ..., 701-P. Chaque circuit de sélection de sortie 703 comprend P entrées IN1, ..., INP et une sortie out. Chaque entrée est reliée à une sortie d'un des générateurs de signaux vobulés 701-1, ..., 701-P, et la sortie fournit le signal Sig-A, respectivement Sig-B. Les circuits de sélection d'entrée et de sortie 702 et 703 comprennent, en outre, une borne de commande cmd recevant un signal commun de commande Chal. Le signal de commande Chal permet de renseigner le circuit de sélection d'entrée 702 quelle sortie est à relier avec l'entrée, et permet de renseigner le circuit de sélection de sortie 703 quelle entrée est à relier avec la sortie. Autrement dit, le signal de commande Chal indique aux circuits de sélection d'entrée et de sortie quel générateur parmi les générateurs 701-1, ..., 701-P est à sélectionner. Selon un mode de réalisation, les circuits de sélection d'entrée et de sortie 702 et 703 des circuits 700-A et 700-B reçoivent le même signal de commande Chal.

Le dispositif 700 comprend, en outre, une unité de commande 730 comprenant un générateur d'un signal vobulé du type du générateur de signal vobulé 100 décrit en relation avec la figure 1. Le générateur de signal vobulé de l'unité de commande 730 est représenté par :

- un bloc 731 représentant le générateur de signal vobulé sans son circuit de régulation ; et
- un bloc 732 (REG) représentant le circuit de régulation du générateur de signal vobulé.

Comme décrit en relation avec la figure 1, le circuit de régulation 732 du générateur 731 est adapté à réguler la fréquence moyenne du signal de sortie du générateur 731 pour que cette fréquence moyenne se rapproche d'une fréquence moyenne de référence $f_{ref}$. Le circuit de régulation 732 du générateur 731 fournit alors le signal de commande CMD7 pour réguler la fréquence du générateur 731 mais aussi pour réguler les fréquences des signaux fournis par les générateurs 701-1, ..., 701-P du circuit 700-A et par les générateurs 701-1, ..., 701-P du circuit 700-B.

Le fonctionnement du dispositif 700 est le suivant. Le signal de commande Chal indique aux circuits de sélection 702 et 703 des circuits 700-A et 700-B le générateur 701-1, ..., ou 701-P à sélectionner. Le signal Init passe à un état haut, et le générateur 701-1, ..., ou 701-P sélectionné fournit le signal de sortie Sig-A, Sig-B dont la fréquence moyenne est régulée par le signal de commande CMD7. Les compteurs 710-A et 710-B fournissent les nombres Nb-A et Nb-B à partir des signaux Sig-A et Sig-B. Le comparateur 720 compare les nombres Nb-A et Nb-B pour fournir le signal PUF_OUT représentant la sortie du dispositif 700.

Un avantage du dispositif 700 est qu'il n'est pas affecté par les phénomènes de verrouillage qui pourraient affecter les générateurs 701-1, ..., 701-P des circuits 700-A et 700-B. En effet, le générateur 700 étant capable de réguler les fréquences moyennes des signaux de sortie de ces générateurs, est capable d'empêcher la mise en place d'un phénomène de verrouillage.

Un autre avantage du dispositif 700 est que le caractère unique et inclonable de la fonction qu'il met en oeuvre n'est pas uniquement dû aux différences liées aux procédés de fabrication mais aussi aux différences provenant des générateurs de signaux vobulés.

Les modes de réalisation du générateur de signal numérique vobulé ont été décrits en relation avec un exemple d'application à un générateur de nombres aléatoires. Toutefois, les modes de réalisation décrits peuvent être utilisés dans d'autres applications comme, par exemple, une horloge instable utilisée en contremesure contre des attaques cryptographiques.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

**Revendications**

1. Générateur (100) d'un signal numérique vobulé (WO_OUT) comprenant une chaine (104) d'éléments de retard (N1, ..., N12) activables adaptés à retarder un signal numérique (SIG) parmi lesquels un premier nombre (k1) de premiers éléments sont actifs, un second nombre (k2) de deuxièmes éléments sont sélectionnables, et un troisième nombre (k3) de troisièmes éléments sont désactivés, la durée entre deux fronts montants consécutifs dudit signal numérique vobulé étant définie par la sélection d'un quatrième nombre (k2(1), ..., k2(4)) des deuxièmes éléments,
le générateur (100) comprenant un circuit de commande (105) adapté à modifier les premiers et troisième nombres (k1, k3) si la fréquence moyenne (Fmoy) dudit signal numérique vobulé (WO_OUT) est différente d'une fréquence de référence (Fcentrale).

2. Procédé de commande d'un générateur (100) d'un signal numérique vobulé (WO_OUT) comprenant une chaine (104) d'éléments de retard (N1, ..., N12) activables adaptés à retarder un signal numérique (SIG) parmi lesquels un premier nombre (k1) de premiers éléments sont actifs, un second nombre (k2) de deuxièmes éléments sont sélectionnables, et un troisième nombre (k3) de troisièmes éléments sont désactivés, la durée entre deux fronts montants consécutifs dudit signal numérique vobulé étant définie par la sélection d'un quatrième nombre (k2(1), ..., k2(4)) des deuxièmes éléments,
le générateur (100) comprenant un circuit de commande (105) adapté à modifier les premiers et troisième nombres (k1, k3) si la fréquence moyenne (Fmoy) dudit signal numérique vobulé (WO_OUT) est différente d'une fréquence de référence (Fcentrale).

3. Générateur selon la revendication 1 ou procédé selon la revendication 2, dans lequel le deuxième nombre (k2) est toujours constant.

4. Générateur selon la revendication 1 ou procédé selon la revendication 2, dans lequel le deuxième nombre (k2) est variable.

5. Générateur selon l'une quelconque des revendications 1, 3 ou 4, ou procédé selon l'une quelconque des revendications 2 à 4, dans lequel si la fréquence moyenne (Fmoy) dudit signal (WO_OUT) est supérieure à la fréquence de référence (Fcentrale) alors le premier nombre (k1) est augmenté, et le troisième nombre (k3) est diminué.

6. Générateur selon l'une quelconque des revendications 1, 3 à 5, ou procédé selon l'une quelconque des revendications 2 à 5, dans lequel si la fréquence moyenne (Fmoy) dudit signal (WO_OUT) est inférieure à la fréquence de référence (Fcentrale) alors le premier nombre (k1) est diminué, et le troisième nombre (k3) est augmenté.

7. Générateur selon l'une quelconque des revendications 1, 3 à 6, ou procédé selon l'une quelconque des revendications 2 à 6, dans lequel le circuit de commande (105 ; 300 ; 400) comprend :

- un générateur (3021 ; 4021) d'un signal d'horloge (Ref) à fréquence constante dont la fréquence est la fréquence de référence (Fcentrale) ;
- un compteur (3023 ; 4023) adapté à compter un nombre de fronts montants dudit signal numérique vobulé (WO_OUT) ; et
- un circuit de compensation (3024 ; 4024) calculant une commande de régulation H.

8. Générateur ou procédé selon la revendication 7, dans lequel ledit générateur (3021 ; 4021) d'un signal d'horloge (Ref) à fréquence constante est une boucle à verrouillage de phase.

9. Générateur ou procédé selon la revendication 7 ou 8, dans lequel, tous les éléments de retard ajoutent une durée de retard identique à un signal numérique, et la commande de régulation H est calculée en utilisant la formule mathématique suivante :

[Math 5]

$$H = \frac{\left(\frac{C}{Rf} - \frac{C}{M}\right)}{S}$$

dans laquelle :

- C représente la durée pendant laquelle ledit compteur (3023) effectue son calcul ;
- Rf représente le nombre de fronts montants de référence ;
- M représente la valeur mesurée par ledit compteur (3023) pendant la durée C ; et
- S représente la durée d'un retard d'un élément de retard.

10. Générateur ou procédé selon la revendication 7 ou 8, dans lequel, tous les éléments de retard ajoutent un retard identique à un signal numérique, et la commande de régulation H est calculée en utilisant la formule mathématique suivante :

[Math 6]

$$H = (M - Rf) * K$$

dans laquelle :

- Rf représente le nombre de fronts montants de référence ;
- M représente la valeur mesurée par un compteur (3023) pendant la durée C ; et
- K est une constante dépendant des durées C et S.

**11.** Générateur ou procédé selon la revendication 10, dans lequel la constante K est donnée par la formule mathématique suivante :

[Math 7]

$$K = \frac{C * S}{Rf * M}$$

**12.** Générateur ou procédé selon la revendication 7 ou 8, dans lequel, tous les éléments de retard ajoutent un retard identique à un signal numérique, et la commande de régulation H est calculée en utilisant la formule mathématique suivante :

[Math 8]

$$\text{H} = (Rf - M)\frac{(2 * T\_clk\_ref)}{S * DIV}$$

dans laquelle :

- Rf représente le nombre de fronts montants de référence ;
- M représente la valeur mesurée par le compteur (4023) ;
- S représente la durée d'un retard d'un élément de retard ;
- T_clk_ref représente la période du signal de référence Ref ; et
- DIV représente le nombre de fronts montants relevé par un circuit diviseur de fréquence (4023) activant ledit compteur (4023).

**13.** Générateur de nombres aléatoires comprenant au moins un générateur d'un signal numérique vobulé selon l'une quelconque des revendications 1, 3 à 12.

**14.** Générateur de nombres aléatoires comprenant au moins deux générateurs de signaux numériques vobulés selon l'une quelconque des revendications 1, 3 à 12.

**15.** Dispositif (700) adapté à mettre en oeuvre une fonction physique inclonable comprenant au moins un générateur d'un signal vobulé selon l'une quelconque des revendications 1, 3 à 12.

**Fig. 1**

EP 4 184 791 A1

# Fig. 2

# Fig. 3

# Fig. 4

302

300

3021    3022    ena  3023    3024    WO_OUT

| Clk_ref | → | Freq_div | → | ena<br>CNT<br>clk | → | Comp | → | SEL | → CMD_N1<br>⋮<br>→ CMD_N12 |

Ref

WO_OUT

CMD_SEL  301

# Fig. 5

400    WO_OUT    4022    ena    4023    4024    WO_OUT

| Freq_div | | en<br>CNT<br>clk | → | Comp | → | SEL | → CMD_N1<br>⋮<br>→ CMD_N12 |

| Clk_ref |

Ref

4021

301

402

# Fig. 6

# Fig. 7

# Fig. 8

Europäisches
Patentamt

European
Patent Office

Office européen
des brevets

# RAPPORT DE RECHERCHE EUROPEENNE

Numéro de la demande

EP 22 20 7851

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2005/072298 A2 (MOTOROLA INC [US]; TOMERLIN ANDREW T [US]; STENGEL ROBERT E [US]) 11 août 2005 (2005-08-11) * page 3, lignes 15-21; figures 1-2,6 * * page 4, ligne 17 – ligne 22; revendication 10 * * page 5, ligne 10 – ligne 14 * * page 7, ligne 8 * * page 9, ligne 26 – page 10, ligne 3 * | 1-8 | INV. H03K5/134 H03L7/08 |
| X | US 2012/068775 A1 (LEISTAD TOR ERIK [NO] ET AL) 22 mars 2012 (2012-03-22) * alinéa [0003]; revendication 1; figures 1-3,5-6 * * alinéa [0015] – alinéa [0018] * * alinéa [0026] – alinéa [0037] * | 1-15 | |
| A | JI-LIANG ZHANG ET AL: "A Survey on Silicon PUFs and Recent Advances in Ring Oscillator PUFs", JOURNAL OF COMPUTER SCIENCE AND TECHNOLOGY, vol. 29, no. 4, 1 juillet 2014 (2014-07-01), pages 664-678, XP055202227, ISSN: 1000-9000, DOI: 10.1007/s11390-014-1458-1 * page 667, alinéa 2.2.3 – page 668; figures 2-4 * | 1-15 | DOMAINES TECHNIQUES RECHERCHES (IPC) H03K H03L |

Le présent rapport a été établi pour toutes les revendications

| Lieu de la recherche | Date d'achèvement de la recherche | Examinateur |
|---|---|---|
| Munich | 24 mars 2023 | Mesplede, Delphine |

EPO FORM 1503 03.82 (P04C02)

**EP 4 184 791 A1**

## ANNEXE AU RAPPORT DE RECHERCHE EUROPEENNE
## RELATIF A LA DEMANDE DE BREVET EUROPEEN NO.

EP 22 20 7851

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

24-03-2023

| Document brevet cité au rapport de recherche | Date de publication | Membre(s) de la famille de brevet(s) | Date de publication |
|---|---|---|---|
| WO 2005072298 A2 | 11-08-2005 | EP 1716639 A2 | 02-11-2006 |
| | | US 2005168260 A1 | 04-08-2005 |
| | | WO 2005072298 A2 | 11-08-2005 |
| US 2012068775 A1 | 22-03-2012 | US 2012068775 A1 | 22-03-2012 |
| | | US 2013027103 A1 | 31-01-2013 |

EPO FORM P0460

Pour tout renseignement concernant cette annexe : voir Journal Officiel de l'Office européen des brevets, No.12/82